(19) Europäisches Patentamt
European Patent Office
Office européen des brevets

(11) **EP 2 745 396 B1**

(12) **EUROPÄISCHE PATENTSCHRIFT**

(45) Veröffentlichungstag und Bekanntmachung des Hinweises auf die Patenterteilung:
**03.01.2018 Patentblatt 2018/01**

(21) Anmeldenummer: **12740543.9**

(22) Anmeldetag: **17.07.2012**

(51) Int Cl.:
*H04L 27/06* (2006.01)          *H03D 1/00* (2006.01)
*G01R 23/16* (2006.01)          *H04L 1/00* (2006.01)
*G06F 1/00* (2006.01)

(86) Internationale Anmeldenummer:
**PCT/EP2012/063983**

(87) Internationale Veröffentlichungsnummer:
**WO 2013/023857 (21.02.2013 Gazette 2013/08)**

(54) **VERFAHREN UND VORRICHTUNG ZUR DETEKTION VON ZEITGLEICH IM SELBEN KANAL ÜBERTRAGENEN FLUGFUNKSIGNALEN**

METHOD AND DEVICE FOR DETECTING AIRCRAFT RADIO SIGNALS TRANSMITTED IN THE SAME CHANNEL SIMULTANEOUSLY

PROCÉDÉ ET DISPOSITIF DE DÉTECTION DE SIGNAUX DE RADIOCOMMUNICATION AÉRONAUTIQUE TRANSMIS SIMULTANÉMENT SUR LE MÊME CANAL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.08.2011 DE 102011080999**

(43) Veröffentlichungstag der Anmeldung:
**25.06.2014 Patentblatt 2014/26**

(73) Patentinhaber: **Rohde & Schwarz GmbH & Co. KG 81671 München (DE)**

(72) Erfinder: **DETERT, Thorben 80634 München (DE)**

(74) Vertreter: **Körfer, Thomas et al Mitscherlich PartmbB Patent- und Rechtsanwälte Sonnenstrasse 33 80331 München (DE)**

(56) Entgegenhaltungen:
DE-A1-102007 037 105     US-A1- 2010 054 352
US-B1- 7 428 270

**Beschreibung**

Die Erfindung betrifft ein Verfahren und eine Vorrichtung zur Detektion von zeitgleich im selben Frequenzkanal übertragenen insbesondere amplitudenmodulierten Flugfunksignalen.

Die Sprachübertragung im Flugfunk zwischen dem in einem Flugzeug befindlichen Piloten und dem an einer Bodenstation befindlichen Flugüberwachungspersonal bzw. zwischen den in unterschiedlichen Flugzeugen jeweils befindlichen Piloten erfolgt auf einer standardisierten Nominalfrequenz mit amplitudenmodulierten Übertragungssignalen. In seltenen Fällen können gleichzeitig mehrere Funkübertragungen bei der identischen Nominalfrequenz erfolgen. Da dies ein kritischer Zustand darstellt, der unter Umständen zu einer fehlerhaften Navigation eines oder mehrerer Piloten führen kann, ist dieser kritische Zustand aus Sicherheitsgründen zu delektieren und den jeweiligen Piloten und dem Flugüberwachungspersonal zu signalisieren.

Aus der US 2010/0067570 A1 und DE 10 2007 037 105 A1 sind ein Verfahren und ein System zur Detektion einer gleichzeitigen Übertragung von amplitudenmodulierten Übertragungssignalen im Flugfunk bekannt. Bei dieser Druckschrift wird der Effekt der Schwebung ausgenutzt, der bei der additiven Superposition von zwei Schwingungen mit näherungsweise identischer Amplitude und geringfügig unterschiedlicher Frequenz auftritt. Die Amplitude des durch Superposition erzeugten Summensignals ändert sich mit der Schwebungsfrequenz, die der Differenz der beiden geringfügig unterschiedlichen Frequenzen entspricht. Die sich entsprechend der Schwebungsfrequenz zeitlich ändernde Amplitude des Summensignals wird über eine Fourier-Transformation als Spektrallinie im Spektrum des Summensignals identifiziert. Das dort beschriebene Verfahren und System eignet sich nachteilig schlecht bei superponierten Übertragungssignalen mit unterschiedlicher Amplitude, wie sie typischerweise bei unterschiedlichen Entfernungen zwischen zwei Sendern und einem Empfänger auftreten.

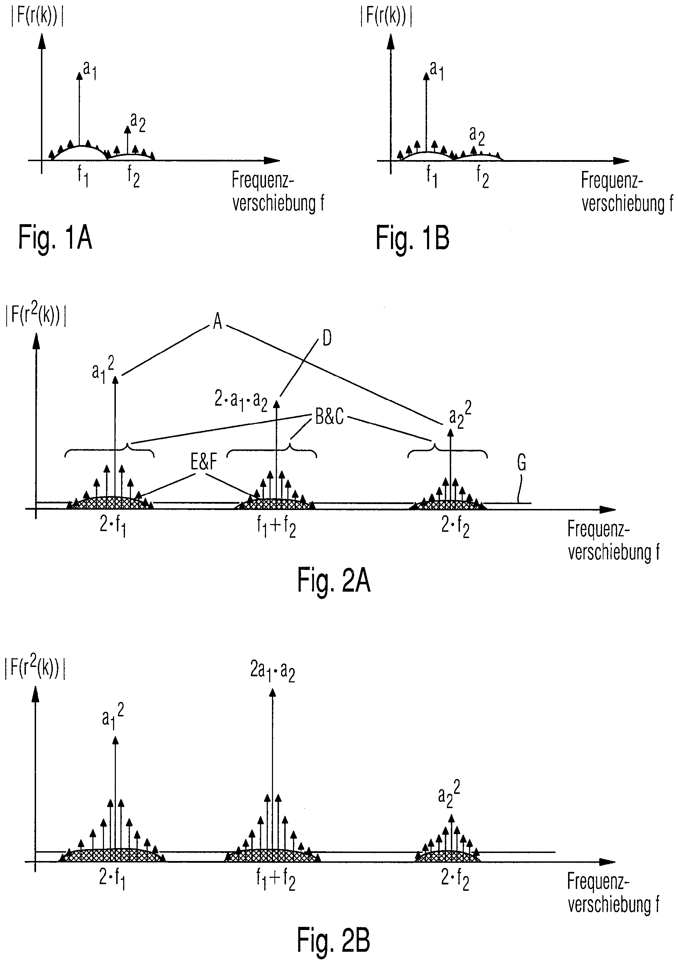

Eine Identifizierung von Mehrfachübertragungen im selben Frequenzkanal des Flugfunks durch Identifizierung der Spektrallinien der zu den gleichzeitig übertragenen Funksignalen jeweils gehörigen Träger bei den durch den Doppler-Effekt oder Oszillator-Verstimmungen verursachten unterschiedlichen Frequenzverschiebungen der Funksignale funktioniert nur befriedigend bei Funksignalen mit hohen Empfangsamplituden der Träger, bei der die Spektrallinien der Träger deutlich über den Spektrallinien und den nicht-periodischen Spektralanteilen des Sprachsignals im oberen und unteren Seitenband und dem Spektrum des überlagerten Rauschens deutlich hinausragen (siehe die Amplituden $a_1$ und $a_2$ der Spektrallinien der Träger im Amplitudenspektrum der Fig. 1A). Verschwinden die Spektrallinien der Träger der übrigen Funksignale dagegen in den Spektralanteilen des Sprach- und Rauschsignals in den zugehörigen oberen und unteren Seitenbändern, so ist eine Detektion von weiteren Funksignalen im Empfangssignal nur schwer möglich (siehe die vergleichsweise kleine Amplitude $a_2$ der Spektrallinie des Trägers des zweiten Funksignals, die im oberen und unteren Seitenband im Amplitudenspektrum der Fig. 1B fast verschwindet).

Aufgabe der Erfindung ist es deshalb, ein Verfahren und ein System zur Detektion einer gleichzeitigen Übertragung von Übertragungssignalen im selben Frequenzkanal zu schaffen, das insbesondere bei unterschiedlicher empfangener Amplitude der beiden Übertragungssignale eingesetzt werden kann.

Die Aufgabe wird durch ein erfindungsgemäßes Verfahren zur Detektion von mindestens zwei in einem Empfangssignal enthaltenen Übertragungssignalen mit unterschiedlicher Frequenzverschiebung mit den Merkmalen des Patentanspruchs 1 und durch eine erfindungsgemäße Vorrichtung zur Detektion von mindestens zwei in einem Empfangssignal enthaltenen Übertragungssignalen mit unterschiedlicher Frequenzverschiebung mit den Merkmalen des Patentanspruchs 16 gelöst. Vorteilhafte technische Erweiterungen sind in den jeweils abhängigen Patentansprüchen aufgeführt.

Erfindungsgemäß wird das aus mindestens zwei Übertragungssignalen zusammengesetzte Empfangssignal einer nichtlinearen Signalverarbeitungsfunktion zugeführt. Aus dem daraus entstandenen modifizierten Empfangssignal wird mittels Fourier-Transformation das zugehörige Spektrum ermittelt. Aufgrund der nichtlinearen Signalverarbeitung enthält das Spektrum des modifizierten Empfangssignals nicht nur Spektrallinien bei den Trägerfrequenzen und in den zugehörigen oberen und unteren Seitenbändern der beiden Übertragungssignale, sondern auch Spektrallinien bei Vielfachen der Trägerfrequenzen sowie in den zugeordneten oberen und unteren Seitenbändern und bei den einzelnen Intermodulationsfrequenzen sowie in den zugeordneten oberen und unteren Seitenbändern.

Während die Spektrallinien des Trägers von einem Übertragungssignal, das eine geringe Empfangsamplitude aufweist, ohne Verwendung einer nichtlinearen Signalverarbeitung typischerweise aus den Spektrallinien in den zugehörigen oberen und unteren Seitenbändern nicht herausragen und somit nicht identifiziert werden können, kommt durch die Verwendung einer nichtlinearen Signalverarbeitung mindestens eine zusätzliche Spektrallinie bei einer Intermodulationsfrequenz hinzu, die aufgrund der nichtlinearen Signalverarbeitung eine Amplitude aufweist, die von der größten Amplitude aller im Empfangssignal enthaltenen Übertragungssignale abhängig ist und somit über alle Spektrallinien des zugehörigen oberen und unteren Seitenbandes hinausragt und eindeutig identifiziert werden kann. Somit wird durch Identifizierung von mindestens zwei Spektrallinien - die Spektrallinie des Trägers mit der größten Amplitude und die Spektrallinie eines Intermodulationsproduktes -, die signifikant über alle Spektrallinien in den einzelnen oberen und unteren Seitenbändern herausragen, ein gleichzeitiger Empfang von mindestens zwei insbesondere amplitudenmodulierten Übertragungssignalen erfindungsgemäß detektiert.

Um die Spektrallinien bei Trägerfrequenzen von Übertragungssignalen mit vergleichsweise geringen Empfangsamplituden, die unter Umständen nicht über die Spektrallinien in den zugehörigen oberen und unteren Seitenbändern hinausragen, auch noch eindeutig zu identifizieren, werden die zur Spektrallinie bei den Trägerfrequenzen und bei den einzelnen Intermodulationsfrequenzen jeweils symmetrisch angeordneten Spektrallinien in den oberen und unteren Seitenbändern vorzugsweise identifiziert und aus dem Spektrum ausgeblendet.

Hierzu bevorzugt wird in einem ersten Schritt das gesamte Empfangsspektrum mittels Bandpassfilterung auf den für die Detektion von mehreren Übertragungssignalen in einem Empfangssignal erforderlichen Frequenzbereich eingeschränkt. Bei Verwendung beispielsweise einer quadratischen Signalverarbeitung als nichtlineare Signalverarbeitung erfolgt die Einschränkung des Spektralbereichs bevorzugt auf den Frequenzbereich, in dem die zweiten Harmonischen der im Empfangssignal enthaltenen Übertragungssignale positioniert sind. Bei Verwendung beispielsweise einer Betragsfunktion als nichtlineare Signalverarbeitung erfolgt die Einschränkung des Spektralbereichs bevorzugt auf den Frequenzbereich im Umfeld der Gleichsignalanteile.

Innerhalb dieses eingeschränkten Spektralbereichs werden nun bevorzugt ausgehend von der Spektrallinie mit der größten Amplitude, die die Spektrallinie des Trägers mit der größten Amplitude darstellt, die zur Spektrallinie mit der nächst kleineren Amplitude spiegelsymmetrisch hinsichtlich der Spektrallinie mit der größten Amplitude positionierte Spektrallinie gesucht. Existiert eine Spektrallinie, deren Frequenzabstand zur Spektrallinie mit der größten Amplitude sich maximal um einen vorgegebenen Schwellwert zum Frequenzabstand zwischen der Spektrallinien mit der größten Amplitude und der Spektrallinien mit der nächst kleineren Amplitude unterscheidet, so liegt ein zur Spektrallinie mit der größten Amplitude frequenzsymmetrisch positioniertes Spektrallinienpaar im jeweiligen oberen und unteren Seitenband vor, die im folgenden als zweite Spektrallinien bezeichnet werden. Dieses Paar von zweiten Spektrallinien wird aus dem eingeschränkten Spektralbereich ausgeblendet.

Auf die gleiche Weise wird vorzugsweise der bereinigte eingeschränkte Frequenzbereich nach weiteren zur Spektrallinie mit der größten Amplitude frequenzsymmetrisch positionierten Spektrallinienpaaren untersucht und bereinigt. Sind auf diese Weise alle im eingeschränkten Spektralbereich vorhandenen Spektrallinien hinsichtlich einer Frequenzsymmetrie zur Spektrallinien mit der größten Amplitude untersucht worden, so wird die Spektrallinie mit der größten Amplitude als asymmetrische Spektrallinie - d.h. eine zu einem Träger oder zu einem Intermodulationsprodukt gehörige Spektrallinie - markiert. Auf diese Weise markierte asymmetrische Spektrallinien werden im Folgenden als erste Spektrallinien bezeichnet.

Anschließend werden bevorzugt alle übrigen im eingeschränkten Frequenzbereich noch vorhandenen Spektrallinien beginnend bei der Spektrallinie mit der nächst kleineren Amplitude hinsichtlich der Existenz von frequenzsymmetrisch positionierten Spektrallinienpaaren untersucht. Liegen derartige frequenzsymmetrisch positionierte Spektrallinienpaare vor, so werden diese aus dem eingeschränkten Spektralbereich ausgeblendet und die zugehörige im Zentrum der Frequenzsymmetrie positionierte Spektrallinie als asymmetrische Spektrallinie gekennzeichnet.

Die eindeutige Identifizierung von ersten Spektrallinien bei jeweils einer Trägerfrequenz und/oder einer Intermodulationsfrequenz innerhalb der im Empfangssignal enthaltenen Sprach- und Rauschsignalanteile ist vorzugsweise anhand von zusätzlichen statistischen Tests zu ermitteln:

In einem Signifikanz-Test wird bevorzugt die Amplitude jeder identifizierten ersten Spektrallinie mit einem gewählten Signifikanzniveau oberhalb des Mittelwerts der Abtastwerte der im Empfangssignal noch enthaltenen Sprach- und Rauschsignalanteile verglichen. Liegt die Amplitude der jeweiligen identifizierten ersten Spektrallinie oberhalb des gewählten Signifikanzniveaus, so liegt eine Spektrallinie eines zu einem Übertragungssignal gehörigen Trägers bei einer Trägerfrequenz, bei Vielfachen einer Trägerfrequenzen und/oder bei einer der Intermodulationsfrequenzen vor. Der Signifikanz-Test eignet sich nur für ein Empfangssignal mit einem ausgeprägten Signal-Rausch-Abstand, bei dem die Spektrallinien der Träger und der zugehörigen Intermodulationsprodukte eindeutig und damit signifikant über den Rauschteppich liegen.

Zur Identifizierung von ersten Spektrallinien, die zu Trägersignalen bzw. zu Intermodulationsprodukten gehören, bei niedrigem Signal-Rausch-Abstand eignet sich bevorzugt die zyklostationäre Eigenschaft-Detektion. In Anlehnung an die US 2010/0054352 A1, deren Offenbarung hiermit als Bestandteil in die vorliegende Patentanmeldung einbezogen wird, weist ein Signal zyklostationäre Eigenschaften auf, wenn dessen Autokorrelationsfunktion periodisch über der Zeit ist. Während ein Rauschsignal aufgrund seiner Stochastik eine zeitinvariante Autokorrelationsfunktion aufweist, besitzt ein reines Sprachsignal aufgrund seiner harmonischen Spektralanteile eine Autokorrelationsfunktion mit einer der Anzahl von harmonischen Spektralanteilen entsprechenden Anzahl von Periodizitäten über der Zeit. Das Vorliegen von mindestens einer Periodizität in der Autokorrelationsfunktion wird mittels Fourier-Transformation identifiziert.

Ein weiterer oder alternativer statistischer Test zur Identifizierung von Spektrallinien, die zu Trägersignalen bzw. zu Intermodulationsprodukten von Trägersignalen gehören, in einem Rauschteppich bei einem niedrigen Signal-Rausch-Abstand erfolgt vorzugsweise mittels Jarque-Bera-Test. Hierbei wird ausgenutzt, dass die Rauschsignalanteile im Empfangssignal einer Gauss-Verteilung gehorchen, während die Spektrallinien der Träger und der Intermodulationsprodukte im Empfangssignal keine Gauss-Charakteristik aufweisen. Wendet man den Jarque-Bera-Test auf die Abtastwerte des von zweiten Spektrallinien befreiten modifizierten Empfangssignals an, so liefert der Jarque-Bera-Test einen Jarque-Bera-Wert, der ein Maß für die Gauss-Charakteristik des modifizierten Empfangssignals ist. Legte dieser Jarque-Bera-Wert oberhalb eines gewählten Schwellwerts, so weist das modifizierte Empfangssignal keine reine Gauss-Charakteristik auf und enthält somit zusätzlich zum reinen Gauss-verteilten Rauschen auch noch nicht-Gauss-verteilte Spektrallinien von Trägern und Intermodulationsprodukten.

Das erfindungsgemäße Verfahren und die erfindungsgemäße Vorrichtung werden im Folgenden anhand der Zeichnung im Detail erläutert. Die Figuren der Zeichnung zeigen:

Fig.1A, 1B    eine spektrale Darstellung des Amplitudenspektrums eines zwei amplitudenmodulierte Übertragungssignale enthaltenden Empfangssignals mit einem zweiten Übertragungssignal mit großer Amplitude und mit kleiner Amplitude,

Fig. 2A, 2B    eine spektrale Darstellung des Amplitudenspektrums eines zwei amplitudenmodulierte Übertragungssignale enthaltenden Empfangssignals mit einem zweiten Übertragungssignal mit großer Amplitude und mit kleiner Amplitude bei erfindungsgemäßer Verwendung einer quadratischen Signalverarbeitung,

Fig. 3A, 3B    eine spektrale Darstellung des Amplitudenspektrums eines zwei amplitudenmodulierte Übertragungssignale enthaltenden Empfangssignals mit einem zweiten Übertragungssignal mit kleiner Amplitude bei Verwendung einer linearen und einer quadratischen Signalverarbeitung,

Fig. 4    eine spektrale Darstellung des Amplitudenspektrums eines zwei amplitudenmodulierte Übertragungssignale enthaltenden Empfangssignal mit einem zweiten Übertragungssignal mit großer Amplitude kleiner Amplitude bei erfindungsgemäßer Verwendung einer Betragsfunktion,

Fig. 5    ein Flussdiagramm eines Ausführungsbeispiels des erfindungsgemäßen Verfahrens zur Detektion von mindestens zwei in einem Empfangssignal enthaltenen amplitudenmodulierten Übertragungssignalen mit unterschiedlicher Frequenzverschiebung und

Fig. 6    ein Blockdiagramm eines Ausführungsbeispiels einer erfindungsgemäßen Vorrichtung zur Detektion von mindestens zwei in einem Empfangssignal enthaltenen amplitudenmodulierten Übertragungssignalen mit unterschiedlicher Frequenzverschiebung.

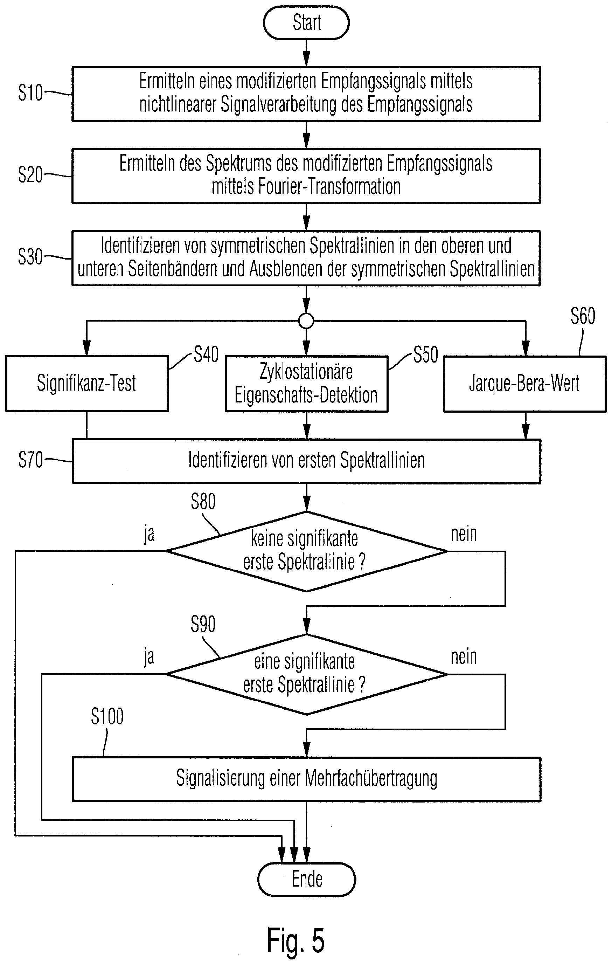

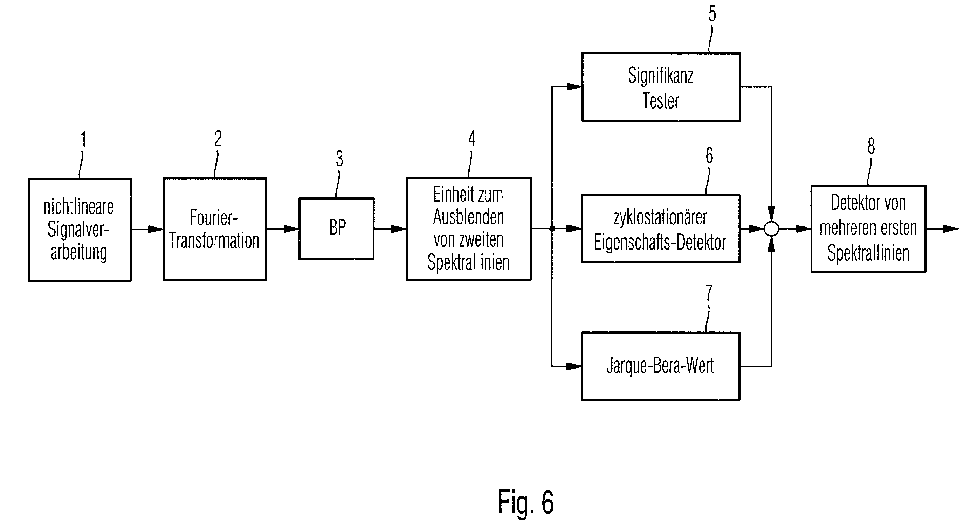

Bevor das erfindungsgemäße Verfahren und die erfindungsgemäße Vorrichtung anhand der Figuren 5 und 6 der Zeichnung im Detail erläutert werden, werden im folgenden die für das Verständnis der Erfindung erforderlichen mathematischen Grundlagen hergeleitet:

Ein abgetastetes, zu sendendes Signal $s(k)$, das mit einem Amplitudenmodulationsgrad $m$ amplitudenmoduliert wird und dessen Träger zusätzlich übertragen wird, erfährt im Übertragungskanal eine Amplitudenverzerrung $a$ und eine Phasenverzerrung $\varphi$ aufgrund fehlenden Phasensynchronisierung zwischen den Oszillatoren der jeweiligen Flugzeugen und der Bodenstation sowie eine Frequenzverschiebung $f$ aufgrund des Doppler-Effekts der mit unterschiedlicher Geschwindigkeit und unterschiedlicher Richtung sich bewegenden Flugzeuge und aufgrund fehlender Frequenzsynchronisierung zwischen den Oszillatoren der jeweiligen Flugzeuge und der Bodenstation. Die Amplitudenverzerrung $a$, die Phasenverzerrung $\varphi$ und die Frequenzverschiebung $f$ werden näherungsweise als konstant während der Dauer der Detektion angenommen. Das abgetastete, zu sendende Signal $s(k)$ und das überlagerte Rauschsignal $n(k)$ werden als unbekannt angesetzt. Das korrespondierende abgetastete Empfangssignal $r(k)$ im Basisband ergibt sich somit gemäß Gleichung (1). $T_S$ ist hierbei das Abtastintervall.

$$r(k) = r(t = k \cdot T_S) = (1 + m \cdot s(k)) \cdot a \cdot e^{j\varphi} \cdot e^{j 2 \pi f k T_S} + n(k) \quad k = ..., -2, -1, 0, 1, 2, ...$$

$$(1)$$

Werden von mehreren Sendern gleichzeitig im selben Frequenzkanal jeweils Übertragungssignale gesendet, so ergibt sich das abgetastete Empfangssignal $r(k)$ bei insgesamt $U$ Sendern gemäß Gleichung (2). Das vom Sender $u$ zu sendende Signal $s_u(k)$ wird mit einem Amplitudenmodulationsgrad $m_u$ amplitudenmoduliert und erfährt eine Amplitudenverzerrung $a_u$, eine Phasenverzerrung $\varphi_u$ und eine Frequenzverschiebung $f_u$.

$$r(k) = \sum_{u=1}^{U} (1 + m_u \cdot s_u(k)) \cdot a \cdot e^{j\varphi_u} \cdot e^{j2\pi f_u kT_S} + n(k) \quad k = ...,-2,-1,0,1,2,... \qquad (2)$$

Im Folgenden wird die Amplitudenverzerrung $a_1$ im Übertragungskanal des ersten Senders gemäß Gleichung (3) größer als die Amplitudenverzerrungen $a_u$ in den Übertragungskanälen der übrigen Sender angenommen.

$$a_1 > a_u \qquad u = 2,3,... \qquad (3)$$

Das insgesamt $U$ Übertragungssignale enthaltende Empfangssignal $r(k)$ gemäß Gleichung (2) wird gemäß Gleichung (4) einer Quadrierung als nichtlineare Signalverarbeitungsfunktion unterworfen.

$$q_r(k) = r(k) \cdot r(k) =$$

$$= \left[ \sum_{u=1}^{U} (1 + m_u \cdot s_u(k)) \cdot a_u \cdot e^{j(2\pi f_u kT_S + \varphi_u)} + n(k) \right] \cdot$$

$$\left[ \sum_{v=1}^{V} (1 + m_v \cdot s_v(k)) \cdot a_v \cdot e^{j(2\pi f_v kT_S + \varphi_v)} + n(k) \right] =$$

$$= \sum_{u=1}^{U} \sum_{v=1}^{V} (1 + m_u \cdot s_u(k)) \cdot (1 + m_v \cdot s_v(k)) \cdot a_u \cdot a_v \cdot e^{j(2\pi(f_u + f_v)kT_S + \varphi_u + \varphi_v)} +$$

$$+ \sum_{u=1}^{U} (1 + m_u \cdot s_u(k)) \cdot a_u \cdot e^{j(2\pi f_u kT_S + \varphi_u)} \cdot n(k) \cdot 2 + n(k)^2 =$$

$$= \sum_{u=1}^{U} (1 + m_u \cdot s_u(k))^2 \cdot a_u^2 \cdot e^{j(2\pi(2 \cdot f_u)kT_S + 2 \cdot \varphi_u)} +$$

$$+ \sum_{\substack{u=1 \\ u \neq v}}^{U} \sum_{v=1}^{V} (1 + m_u \cdot s_u(k)) \cdot (1 + m_v \cdot s_v(k)) \cdot a_u \cdot a_v \cdot e^{j(2\pi(f_u + f_v)kT_S + \varphi_u + \varphi_v)} +$$

$$+ \sum_{u=1}^{U} (1 + m_u \cdot s_u(k)) \cdot a_u \cdot e^{j(2\pi f_u kT_S + \varphi_u)} \cdot 2 \cdot n(k) + n(k)^2 =$$

$$= \underbrace{\sum_{u=1}^{U} a_u^2 \cdot e^{j(2\pi(2 \cdot f_u)kT_S + 2 \cdot \varphi_u)}}_{A} + \underbrace{\sum_{u=1}^{U} 2 \cdot m_u \cdot s_u(k) \cdot a_u^2 \cdot e^{j(2\pi(2 \cdot f_u)kT_S + 2 \cdot \varphi_u)}}_{B} +$$

$$+ \underbrace{\sum_{u=1}^{U} m_u^2 \cdot s_u(k)^2 \cdot a_u^2 \cdot e^{j(2\pi(2 \cdot f_u)kT_S + 2 \cdot \varphi_u)}}_{C} +$$

$$+ \underbrace{\sum_{\substack{u=1 \\ u \neq v}}^{U} \sum_{v=1}^{V} a_u \cdot a_v \cdot e^{j(2\pi(f_u + f_v)kT_S + \varphi_u + \varphi_v)}}_{D} +$$

$$+ \underbrace{\sum_{\substack{u=1 \\ u \neq v}}^{U} \sum_{v=1}^{V} (m_u \cdot s_u(k) + m_v \cdot s_v(k) + m_u \cdot s_u(k) \cdot m_v \cdot s_v(k)) \cdot a_u \cdot a_v \cdot e^{j(2\pi(f_u + f_v)kT_S + \varphi_u + \varphi_v)}}_{E} +$$

$$+ \underbrace{2 \cdot n(k) \cdot \sum_{u=1}^{U} (1 + m_u \cdot s_u(k)) \cdot a_u \cdot e^{j(2\pi f_u kT_S + \varphi_u)}}_{F} + \underbrace{n(k)^2}_{G}$$

$$(4)$$

Nach Ausmultiplizieren sämtlicher Faktoren in Gleichung (4) erhält man folgende einzelne Signalanteile:

Die erste Summe $A$ in Gleichung (4) enthält gemäß Gleichung (5) alle Signalanteile der in den einzelnen Übertragungssignalen jeweils zusätzlich übertragenen Träger, die jeweils eine Periodizität mit der doppelten zugehörigen Frequenzverschiebung $2 \cdot f_u$ aufweisen und mit dem quadrierten Faktor der Amplitudenverzerrung $a_u^2$ gewichtet sind. Das zugehörige Spektrum der ersten Summe $A$ enthält jeweils die zu den Trägern gehörigen Spektrallinien bei der jeweils zugehörigen doppelten Frequenzverschiebung $2 \cdot f_u$.

$$A = \sum_{u=1}^{U} a_u^{\,2} \cdot e^{j(2\pi(2\cdot f_u)kT_S + 2\cdot \varphi_u)} \qquad (5)$$

Die zweite Summe $B$ in Gleichung (4) enthält gemäß Gleichung (6) alle Signalanteile, die zu den amplituden-modulierten Sprachsignalen $m_u \cdot s_u(k)$ in den oberen und unteren Seitenbändern gehören und jeweils eine Periodizität mit der doppelten zugehörigen Frequenzverschiebung $2 \cdot f_u$ aufweisen. Das zugehörige Spektrum der zweiten Summe $B$ enthält jeweils die zu den amplitudenmodulierten Sprachsignalen gehörigen Spektrallinien im oberen und unteren Seitenband symmetrisch zur jeweils zugehörigen doppelten Frequenzverschiebung $2 \cdot f_u$. Die zu den amplitudenmodu-lierten Sprachsignalen $m_u \cdot s_u(k)$ gehörigen Signalanteile im Zeitbereich sowie die zugehörigen Spektrallinien im Frequenzbereich sind jeweils um den quadrierten Faktor der Amplitudenverzerrung $a_u^2$ gewichtet.

$$B = \sum_{u=1}^{U} 2 \cdot m_u \cdot s_u(k) \cdot a_u^{\,2} \cdot e^{j(2\pi(2\cdot f_u)kT_S + 2\cdot \varphi_u)} \qquad (6)$$

Die dritte Summe $C$ in Gleichung (4) enthält gemäß Gleichung (7) alle Signalanteile, die zu den verzerrten amplitudenmodulierten Sprachsignalen $m_u^2 \cdot s_u(k)^2$ in den oberen und unteren Seitenbändern gehören und jeweils eine Periodizität mit der doppelten zugehörigen Frequenzverschiebung $2 \cdot f_u$ aufweisen. Das zugehörige Spektrum der dritten Summe $C$ enthält jeweils die zu den verzerrten amplitudenmodulierten Sprachsignalen $m_u^2 \cdot s_u(k)^2$ gehörigen Spektral-linien im oberen und unteren Seitenband symmetrisch zur jeweils zugehörigen doppelten Frequenzverschiebung $2 \cdot f_u$. Die zu den verzerrten amplitudenmodulierten Sprachsignalen $m_u^2 \cdot s_u(k)^2$ gehörigen Signalanteile im Zeitbereich sowie die zugehörigen Spektrallinien im Frequenzbereich sind jeweils um den quadrierten Faktor der Amplitudenverzerrung $a_u^2$ gewichtet.

$$C = \sum_{u=1}^{U} m_u^{\,2} \cdot s_u(k)^2 \cdot a_u^{\,2} \cdot e^{j(2\pi(2\cdot f_u)kT_S + 2\cdot \varphi_u)} \qquad (7)$$

Die vierte Summe $D$ in Gleichung (4) enthält gemäß Gleichung (8) alle Signalanteile der in den einzelnen Übertragungssignalen jeweils zusätzlich übertragenen Träger, die jeweils eine Periodizität bei den Intermodulationsfre-quenzen der zugehörigen Frequenzverschiebungen $f_u + l_v$ aufweisen und mit den multiplizierten Faktoren der zugehö-rigen Amplitudenverzerrungen $a_u \cdot a_v$ gewichtet sind. Das zugehörige Spektrum der vierten Summe $D$ enthält jeweils die zu den Intermodulationsprodukten von zwei Trägern gehörigen Spektrallinien bei den Intermodulationsfrequenzen der zugehörigen Frequenzverschiebungen $f_u + f_v$.

$$D = \sum_{u=1}^{U} \sum_{\substack{v=1 \\ u \neq v}}^{V} a_u \cdot a_v \cdot e^{j(2\pi(f_u + f_v)kT_S + \varphi_u + \varphi_v)} \qquad (8)$$

Die fünfte Summe $E$ in Gleichung (4) enthält gemäß Gleichung (9) alle Signalanteile, die zu den unverzerrten amplitudenmodulierten Sprachsignalen $m_u \cdot s_u(k) + m_v \cdot s_v(k)$ und zu den verzerrten amplitudenmodulierten Sprachsig-nalen $m_u \cdot m_v \cdot s_u(k) \cdot s_v(k)$ in den oberen und unteren Seitenbändern gehören und jeweils eine Periodizität bei den Inter-modulationsfrequenzen der zugehörigen Frequenzverschiebungen $f_u + l_v$ aufweisen. Das zugehörige Spektrum der fünften Summe $E$ enthält jeweils die zu den unverzerrten amplitudenmodulierten Sprachsignalen $m_u \cdot s_u(k) + m_v \cdot s_v(k)$ und zu den verzerrten amplitudenmodulierten Sprachsignalen $m_u \cdot m_v \cdot s_u(k) \cdot s_v(k)$ gehörigen Spektrallinien im oberen und unteren Seitenband symmetrisch zu den jeweiligen Intermodulationsfrequenzen der zugehörigen Frequenzverschie-bungen $f_u + l_v$. Die Signalanteilen der fünften Summe $E$ im Zeitbereich und die zugehörigen Spektrallinien im Frequenzbereich sind jeweils mit den multiplizierten Faktoren der zugehörigen Amplitudenverzerrungen $a_u \cdot a_v$ gewichtet.

$$E = \sum_{u=1}^{U} \sum_{\substack{v=1 \\ u \neq v}}^{V} (m_u \cdot s_u(k) + m_v \cdot s_v(k) + m_u \cdot s_u(k) \cdot m_v \cdot s_v(k)) \cdot a_u \cdot a_v \cdot e^{j(2\pi(f_u + f_v)kT_S + \varphi_u + \varphi_v)} \qquad (9)$$

Die sechste Summe $F$ in Gleichung (4) enthält gemäß Gleichung (10) alle Signalanteile, die zu allen mit dem Rauschsignal $n(k)$ überlagerten amplitudenmodulierten Sprachsignalen $m_u \cdot s_u(k)$ und zu den im jeweiligen Übertragungskanal zusätzlich übertragenen und ebenfalls mit dem Rauschsignal $n(k)$ überlagerten Trägern gehören und eine Periodizität bei der zugehörigen Frequenzverschiebung $f_u$ aufweisen. Diese Signalanteile sind mit dem Faktor der zugehörigen Amplitudenverzerrung $a_u$ gewichtet und stellen aufgrund fehlender Korrelation zum stochastischen Rauschsignal $n(k)$ unkorrelierte Signalanteile dar. Das zugehörige Spektrum der sechsten Summe $F$ enthält jeweils unkorrelierte Spektralanteile im oberen und unteren Seitenband symmetrisch zur zugehörigen Frequenzverschiebung $f_u$.

$$F = 2 \cdot n(k) \cdot \sum_{u=1}^{U} (1 + m_u \cdot s_u(k)) \cdot a_u \cdot e^{j(2\pi f_u k T_S + \varphi_u)} \qquad (10)$$

Der siebte Term $G$ in Gleichung (4) enthält gemäß Gleichung (11) das quadrierte unkorrelierte Rauschsignal $n(k)$. Das zugehörige Spektrum des siebten Terms $G$ enthält unkorrelierte Spektralanteile.

$$G = n(k)^2 \qquad (11)$$

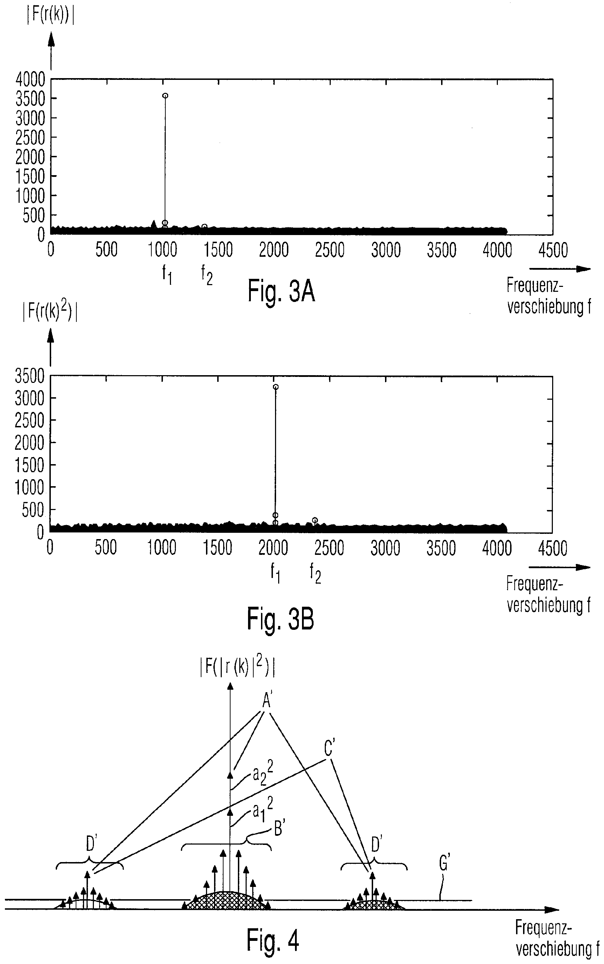

Bei zwei Sendern sind die zu den einzelnen Summen $A$ bis $F$ und zu dem Term $G$ jeweils gehörigen Spektralanteile im Amplitudenspektrum des modifizierten Empfangssignals der Fig. 2A für den Fall eines zweiten Senders mit einer vergleichsweise höheren Amplitude $a_2$ und im Amplitudenspektrum des modifizierten Empfangssignals der Fig. 2B für den Fall eines zweiten Senders mit einer vergleichsweise niedrigeren Amplitude $a_2$ bei Verwendung einer quadratischen Signalverarbeitung dargestellt. In den Figuren 3A und 3B werden Amplitudenspektren eines Empfangssignals bzw. modifizierten Empfangssignals mit einem zweiten Übertragungssignal mit vergleichsweise niedriger Amplitude $a_2$ bei Verwendung einer linearen Signalverarbeitung bzw. bei einer quadratischen Signalverarbeitung verglichen.

Wird das insgesamt $U$ Übertragungssignale enthaltende Empfangssignal $r(k)$ gemäß Gleichung (2) einer Betragsfunktion als nichtlineare Signalverarbeitungsfunktion unterworfen, so ergeben sich gemäß Gleichung (12) nach dem Ausmultiplizieren der einzelnen Faktoren folgende Signalanteile:

$$p_r(k) = r(k) \cdot r(k) =$$

$$= \left[ \sum_{u=1}^{U} (1 + m_u \cdot s_u(k)) \cdot a_u \cdot e^{j(2\pi f_u kT_S + \varphi_u)} + n(k) \right] \cdot$$

$$\left[ \sum_{v=1}^{V} (1 + m_v \cdot s_v(k)) \cdot a_v \cdot e^{j(2\pi f_v kT_S + \varphi_v)} + n(k) \right]^* =$$

$$= \sum_{u=1}^{U} \sum_{v=1}^{V} (1 + m_u \cdot s_u(k)) \cdot (1 + m_v \cdot s_v(k)) \cdot a_u \cdot a_v \cdot e^{j(2\pi (f_u - f_v) kT_S + \varphi_u - \varphi_v)} +$$

$$+ \sum_{u=1}^{U} (1 + m_u \cdot s_u(k)) \cdot a_u \cdot e^{j(2\pi f_u kT_S + \varphi_u)} \cdot n(k) \cdot 2 + n(k)^2 =$$

$$= \sum_{u=1}^{U} (1 + m_u \cdot s_u(k))^2 \cdot a_u^2 \cdot e^{j(2\pi(2 \cdot f_u) kT_S + 2 \cdot \varphi_u)} +$$

$$+ \sum_{\substack{u=1 \\ u \neq v}}^{U} \sum_{v=1}^{V} (1 + m_u \cdot s_u(k)) \cdot (1 + m_v \cdot s_v(k)) \cdot a_u \cdot a_v \cdot e^{j(2\pi(f_u - f_v)kT_S + \varphi_u - \varphi_v)} +$$

$$+ \sum_{u=1}^{U} (1 + m_u \cdot s_u(k)) \cdot a_u \cdot e^{j(2\pi f_u kT_S + \varphi_u)} \cdot n(k)^* +$$

$$+ \sum_{v=1}^{V} (1 + m_v \cdot s_v(k)) \cdot a_v \cdot e^{j(2\pi f_v kT_S + \varphi_v)} \cdot n(k) + |n(k)|^2 =$$

$$= \underbrace{\sum_{u=1}^{U} a_u^2}_{A'} + \underbrace{\sum_{u=1}^{U} m_u^2 \cdot s_u(k)^2 \cdot a_u^2}_{B'} + \underbrace{\sum_{\substack{u=1 \\ u \neq v}}^{U} \sum_{v=1}^{V} a_u \cdot a_v \cdot e^{j(2\pi(f_u - f_v)kT_S + \varphi_u - \varphi_v)}}_{C'} +$$

$$+ \underbrace{\sum_{\substack{u=1 \\ u \neq v}}^{U} \sum_{v=1}^{V} (m_u \cdot s_u(k) + m_v \cdot s_v(k) + m_u \cdot s_u(k) \cdot m_v \cdot s_v(k)) \cdot a_u \cdot a_v \cdot e^{j(2\pi(f_u - f_v)kT_S + \varphi_u - \varphi_v)}}_{D'} +$$

$$+ \underbrace{\sum_{u=1}^{U} (1 + m_u \cdot s_u(k)) \cdot a_u \cdot e^{j(2\pi f_u kT_S + \varphi_u)} \cdot n(k)^*}_{E'} + \underbrace{\sum_{v=1}^{V} (1 + m_v \cdot s_v(k)) \cdot a_v \cdot e^{j(2\pi f_v kT_S + \varphi_v)} \cdot n(k)}_{F'} +$$

$$+ \underbrace{|n(k)|^2}_{G'} \qquad\qquad (12)$$

Die erste Summe *A'* in Gleichung (12) enthält gemäß Gleichung (13) alle Signalanteile der in den einzelnen Übertragungssignale jeweils zusätzlich übertragenen Träger, die jeweils mit dem quadrierten Faktor der Amplitudenverzerrung $a_u^2$ gewichtet sind und reine Gleichsignalanteile darstellen.

$$A' = \sum_{u=1}^{U} a_u^2 \qquad\qquad (13)$$

Die zweite Summe B' in Gleichung (12) enthält gemäß Gleichung (14) alle Signalanteile, die zu den verzerrten amplitudenmodulierten Sprachsignalen $m_u^2 \cdot s_u(k)^2$ in den oberen und unteren Seitenbändern gehören und jeweils Gleichsignalanteile darstellen. Das zugehörige Spektrum der zweiten Summe *B'* enthält jeweils die zu den verzerrten amplitudenmodulierten Sprachsignalen gehörigen Spektrallinien im oberen und unteren Seitenband symmetrisch zur Nullfrequenz. Die zu den verzerrten amplitudenmodulierten Sprachsignalen $m_u{}^2 \cdot s_u(k)^2$ gehörigen Signalanteile im Zeitbereich sowie die zugehörigen Spektrallinien im Frequenzbereich sind jeweils um den quadrierten Faktor der Amplitudenverzerrung $a_u{}^2$ gewichtet.

$$B' = \sum_{u=1}^{U} m_u{}^2 \cdot s_u(k)^2 \cdot a_u{}^2 \qquad (14)$$

Die dritte Summe $C'$ in Gleichung (12) enthält gemäß Gleichung (15) alle Signalanteile der in den einzelnen Übertragungssignalen jeweils zusätzlich übertragenen Träger, die jeweils eine Periodizität bei den Intermodulationsfrequenzen der zugehörigen Frequenzverschiebungen $f_u$-$f_v$ bzw. $f_v$-$f_u$ aufweisen und mit den multiplizierten Faktoren der zugehörigen Amplitudenverzerrungen $a_u \cdot a_v$ gewichtet sind. Das zugehörige Spektrum der dritten Summe $C'$ enthält jeweils die zu den Intermodulationsprodukten von zwei Trägern gehörigen Spektrallinien bei den Intermodulationsfrequenzen der zugehörigen Frequenzverschiebungen $f_u$ - $f_v$ bzw. $l_v$-$f_u$.

$$C' = \sum_{\substack{u=1 \\ u \neq v}}^{U} \sum_{v=1}^{V} a_u \cdot a_v \cdot e^{j(2\pi(f_u - f_v)kT_S + \varphi_u - \varphi_v)} \qquad (15)$$

Die vierte Summe $D'$ in Gleichung (12) enthält gemäß Gleichung (16) alle Signalanteile, die zu den unverzerrten amplitudenmodulierten Sprachsignalen $m_u \cdot s_u(k) + m_v \cdot s_v(k)$ und zu den verzerrten amplitudenmodulierten Sprachsignalen $m_u \cdot m_v \cdot s_u(k) \cdot s_v(k)$ in den oberen und unteren Seitenbändern gehören und jeweils eine Periodizität bei den Intermodulationsfrequenzen der zugehörigen Frequenzverschiebungen $f_u$ - $f_v$ bzw. $f_v$-$f_u$ aufweisen. Das zugehörige Spektrum der vierten Summe $D'$ enthält jeweils die zu den unverzerrten amplitudenmodulierten Sprachsignalen $m_u \cdot s_u(k) + m_v \cdot s_v(k)$ und zu den verzerrten amplitudenmodulierten Sprachsignalen $m_u \cdot m_v \cdot s_u(k) - s_v(k)$ gehörigen Spektrallinien im oberen und unteren Seitenband symmetrisch zu den jeweiligen Intermodulationsfrequenzen der zugehörigen Frequenzverschiebungen $f_u$ - $f_v$ bzw. $l_v$-$f_u$. Die Signalanteile der vierten Summe $D'$ im Zeitbereich und die zugehörigen Spektrallinien im Frequenzbereich sind jeweils mit den multiplizierten Faktoren der zugehörigen Amplitudenverzerrungen $a_u \cdot a_v$ gewichtet.

$$D' = \sum_{\substack{u=1 \\ u \neq v}}^{U} \sum_{v=1}^{V} (m_u \cdot s_u(k) + m_v \cdot s_v(k) + m_u \cdot s_u(k) \cdot m_v \cdot s_v(k)) \cdot a_u \cdot a_v \cdot e^{j(2\pi(f_u - f_v)kT_S + \varphi_u - \varphi_v)}$$

$$(16)$$

Der siebte Term $H'$ in Gleichung (12) enthält gemäß Gleichung (17) den quadrierten Betrag $|n(k)|^2$ des unkorrelierten Rauschsignals.

$$G' = \left| n(k) \right|^2 \qquad (17)$$

Die fünfte Summe $E'$ in Gleichung (12) mit den in den einzelnen Übertragungssignale zusätzlich übertragenen Trägern und den einzelnen amplitudenmodulierten Sprachsignalen $m_u \cdot s_u(k)$, die jeweils eine Periodizität bei der zugehörigen Frequenzverschiebung $f_u$ aufweisen und mit dem Faktor der zugehörigen Amplitudenverzerrung $a_u$ gewichtet sind, und die sechste Summe $F'$ in Gleichung (12) mit den in den einzelnen Übertragungssignale zusätzlich übertragenen Trägern und den einzelnen amplitudenmodulierten Sprachsignalen $m_u \cdot s_u(k)$, die jeweils eine Periodizität bei der zugehörigen negativen Frequenzverschiebung $-f_v$ aufweisen und mit dem Faktor der zugehörigen Amplitudenverzerrung $a_v$ gewichtet sind, werden durch ein Bandpassfilter mit einer Mittenfrequenz bei der Nullfrequenz für die weitere Analyse ausgeblendet.

Bei zwei Sendern sind die zu den einzelnen Summen $A'$ bis $D'$ und zu dem Term $H'$ jeweils gehörigen Spektralanteile im Amplitudenspektrum des modifizierten Empfangssignals der Fig. 4 mit einem zweiten Übertragungssignal mit einer vergleichsweise niedrigen Amplitude $a_2$ dargestellt.

Neben diesen Nichtlinearitäten zweiter Ordnung können selbstverständlich Nichtlinearitäten höherer Ordnung verwendet werden. Auf die mathematische Herleitung der bei nichtlinearer Signalverarbeitung höherer Ordnung entstehenden Signalanteile des Empfangssignals wird an dieser Stelle verzichtet. Prinzipiell steigt die Anzahl der zu den Trägersignalen und zu den periodischen Signalanteilen des Sprachsignals jeweils gehörigen Spektrallinien mit der Ordnung der Nichtlinearität an. Der Signalverarbeitungsaufwand zur Detektion von mindestens zwei im Empfangssignal enthaltenen Übertragungssignalen bei Verwendung einer Nichtlinearität höherer Ordnung steigt somit durch die Vielzahl von zu analysierenden Spektrallinien auch deutlich an und ist deshalb für den Einsatz in der Praxis weniger geeignet.

Um eindeutige Detektions-Kriterien für die Identifizierung von mindestens zwei Übertragungssignalen im Empfangssignal zu gewinnen, sind die für die Detektion wesentlichen Spektrallinien der Trägersignale und der Intermodulationsprodukte von der Vielzahl von Spektrallinien und von der Vielzahl von unkorrelierten Spektralanteilen, die bei der nichtlinearen Signalverarbeitung entstehen, zu trennen.

In einem ersten Schritt werden die zu den Sprachsignalanteilen gehörigen Spektrallinien aus dem Spektrum des durch eine Nichtlinearität verarbeiteten Empfangssignals ausgeblendet. Für eine erfolgreiche Ausblendung der zu den Sprachsignalanteilen gehörigen Spektrallinien ist die Kenntnis der Auswirkung der Nichtlinearität auf die Spektrallinien der Sprachsignale von wesentlicher Bedeutung. Hierzu wird ausgehend vom Empfangssignal im Basisband gemäß Gleichung (1) das hochfrequente Empfangssignal zur Durchführung der nichtlinearen Signalverarbeitung betrachtet. Gemäß Gleichung (18) ist das hochfrequente Empfangssignal gegenüber dem Empfangssignal im Basisband auf einem Träger mit der Trägerfrequenz $f_c$ und der Trägerphase $\varphi_c$ moduliert und mit dem reellen Verstärkungsfaktor $P$ des Sendeverstärkers verstärkt.

$$r_{HF}(t) = P \cdot \left(1 + m \cdot s(t)\right) \cdot \cos\left(2\pi f_c t + \varphi_c\right) \qquad (18)$$

Bei dem hochfrequenten Empfangssignal $r_{HF}(t)$ gemäß Gleichung (18) handelt es sich somit um ein reelles Zeitsignal, das einen gerades Amplitudenspektrum und ein ungerades Phasenspektrum aufweist. Ein derartiges Signal ist somit konjugiert-symmetrisch zur Nullfrequenz. Das obere und untere Seitenband des hochfrequenten Empfangssignals $r_{HF}(t)$ konjugiert-symmetrisch Trägerfrequenz $f_c$.

Wird dieses hochfrequente Empfangssignal $r_{HF}(t)$ gemäß Gleichung (18) einer Nichtlinearität zugeführt, so ergibt sich das modifizierte hochfrequente Empfangssignal $r_{HF}(t)'$ gemäß Gleichung (19).

$$r_{HF}(t)' = F\left\{P \cdot \left(1 + m \cdot s(t)\right) \cdot \cos(2\pi f_c t + \varphi_c)\right\} \qquad (19)$$

Da das Argument der nichtlinearen Funktion $F\{.\}$ eine periodische Funktion mit der Trägerfrequenz $f_c$ als Periodizität ist, ist auch das Ergebnis der nichtlinearen Funktion $F\{.\}$ gemäß Gleichung (20) eine periodische Funktion, die als Fourier-Reihe mit von der Trägerfrequenz $f_c$ und von Vielfachen der Trägerfrequenz $f_c$ jeweils abhängigen Harmonischen und mit den Fourier-Koeffizienten $\alpha_k$ und $\beta_k$ gemäß Gleichung (21) und (22) darstellbar ist.

$$r_{HF}(t)' = \sum_{k=1}^{\infty} \alpha_k \cdot \cos(k \cdot \alpha) + \beta_k \cdot \sin(k \cdot \alpha) \quad \text{mit} \quad \alpha = 2\pi f_c t + \varphi_c \qquad (20)$$

$$\alpha_k = \frac{1}{\pi} \int_0^{2\pi} F\left\{A(t) \cdot \cos\alpha\right\} \cdot \cos(k \cdot \alpha) d\alpha \quad \text{mit} \quad A(t) = P \cdot (1 + m \cdot s(t)) \qquad (21)$$

$$\beta_k = \frac{1}{\pi} \int_0^{2\pi} F\left\{A(t) \cdot \cos\alpha\right\} \cdot \sin(k \cdot \alpha) d\alpha \qquad (22)$$

Wird das Ergebnis der nichtlinearen Funktion $F\{.\}$ lediglich durch die ersten Harmonischen genähert, so gehen die Gleichungen (20) bis (22) in die Gleichungen (23) bis (25) über.

$$r_{HF}(t)' = f_1(A(t)) \cdot \cos(2\pi f_c t + \varphi_c) + f_2(A(t)) \cdot \sin(2\pi f_c t + \varphi_c) \qquad (23)$$

$$f_1(A(t)) = \alpha_1 = \frac{1}{\pi} \int_0^{2\pi} F\{A(t) \cdot \cos\alpha\} \cdot \cos\alpha \, d\alpha \qquad (24)$$

$$f_2(A(t)) = \beta_1 = \frac{1}{\pi} \int_0^{2\pi} F\{A(t) \cdot \cos\alpha\} \cdot \sin\alpha \, d\alpha \qquad (25)$$

Die beiden Fourier-Koeffizienten $f_1(A(t))$ und $f_2(A(t))$ gemäß Gleichung (24) und (25) stellen den Realteil und den Imaginärteil der komplexen Zahl $f_1(A(t))+j\cdot f_2(A(t))$ dar. Somit kann das Ergebnis der nichtlinearen Funktion $F\{.\}$ gemäß Gleichung (23) nach Gleichung (26) übergeführt werden, die das Amplituden-Übertragungsverhalten $f(A(t))$ - die so genannte AM-AM-Charakteristik - der Nichtlinearität $F\{.\}$ gemäß Gleichung (27) und das Amplituden-Phasen-Übertragungsverhalten $g(A(t))$ - die so genannte AM-PM-Charakteristik - der Nichtlinearität $F\{.\}$ gemäß Gleichung (28) be-rücksichtigt.

$$r_{HF}(t)' = f(A(t)) \cdot \cos(2\pi f_c t + \varphi_c + g(A(t))) \qquad (26)$$

$$f(A(t)) = \sqrt{f_1(A(t))^2 + f_2(A(t))^2} \qquad (27)$$

$$g(A(t)) = \arctan\left(\frac{f_2(A(t))}{f_1(A(t))}\right) \qquad (28)$$

Das hochfrequente, durch die Nichtlinearität modifizierte Empfangssignal $r_{HF}(t)$' gemäß Gleichung (26) bleibt reell, so dass das zugehörige Spektrum konjugiert-symmetrisch zur Nullfrequenz ist. Die Spektrallinien und unkorrelierten Spektralanteile des Sprachsignals $m\cdot s(t)$ in den oberen und unteren Seitenbändern sind aufgrund der AM-AM-Charakteristik der Nichtlinearität amplitudenverzerrt. Die Amplituden der Spektrallinien und die unkorrelierten Spektralanteile des Sprachsignals $m\cdot s(t)$ in den oberen und unteren Seitenbändern weisen aber eine gerade Symmetrie hinsichtlich der Trägerfrequenz auf. Die Phasen der Spektrallinien und die unkorrelierten Spektralanteile des Sprachsignals $m\cdot s(t)$ verlieren aber aufgrund AM-PM-Charakteristik der Nichtlinearität ihre ungerade Symmetrie hinsichtlich der Trägerfrequenz. Somit sind sie nicht mehr exakt konjugiert-symmetrisch zur Trägerfrequenz. Sie sind aber nach wie vor frequenzsymmetrisch zur Trägerfrequenz angeordnet.

Somit lassen sich die symmetrisch im jeweils oberen und unteren Seitenband zu den einzelnen Trägern angeordnete Paare von Spektrallinien des Sprachsignals nicht anhand ihrer Amplitude und Phase, sondern lediglich anhand ihres identischen Frequenzabstandes zu Frequenz des jeweiligen Trägers identifizieren. Das Paar von Spektrallinien bei den Frequenzen $f_{lSp}$ und $f_{rSp}$ weisen jeweils einen Frequenzabstand $f_{lSp}$-$f_{Tr}$ und $f_{rSp}$-$f_{Tr}$ zur Frequenz $f_{Tr}$ des jeweiligen Trägers auf, die nie exakt identisch sind. Zur Identifizierung eines Paares von symmetrisch zum Träger positionierten Spektrallinien des Sprachsignals wird deshalb die Differenz der beiden Frequenzabstände mit einem ersten Schwellen-wert $SW_1$ gemäß Gleichung (29) verglichen. Ist die Differenz der beiden Frequenzabstände kleiner als der erste Schwell-wert $SW_1$, so liegt ein Paar von symmetrisch zum Träger positionierten Spektrallinien des Sprachsignals vor, das aus dem Spektrum ausgeblendet werden kann.

$$(f_{lSp} - f_{Tr}) - (f_{rSp} - f_{Tr}) < SW1 \qquad (29)$$

Sind die einzelnen symmetrisch zur Spektrallinien der Träger und/oder der Intermodulationsprodukte angeordneten Paare von Spektrallinien - die sogenannten zweiten Spektrallinien - in Summe aus dem betrachteten Spektrum des nichtlinearen modifizierten Empfangssignals ausgeblendet, so müssen die asymmetrisch positionierten Spektrallinien der Träger und/oder der Intermodulationsprodukte - die so genannte ersten Spektrallinien - aus den unkorrelierten Spektralanteilen des Sprachsignals und aus dem rechtlichen Rauschteppich eindeutig selektiert werden.

Für den Fall, dass ein vergleichsweise hoher Signal-Rausch-Abstand vorliegt und somit erste Spektrallinien sich signifikant von den unkorrelierten Spektralanteilen des Sprachsignals und des rechtlichen Rauschteppichs unterscheiden, kann mithilfe eines Signifikanz-Tests eine erste Spektrallinie detektiert werden, wenn die Amplitude $\hat{x}_1$ der ersten Spektrallinie gemäß Gleichung (30) höher als einer als Signifikanz-Niveau dienender zweiter Schwellwert $SW_2$ über dem Mittelwert $E\{x_i\}$ sämtlicher Abtastwerte $x_i$ des von zweiten Spektrallinien befreiten Spektrums des modifizierten Empfangssignals ist.

$$\hat{x}_1 > SW_2 + E\{x_i\} \qquad (30)$$

Bei ersten Spektrallinien, die nicht signifikant aus dem Rauschteppich und den unkorrelierten Spektralanteile des Sprachsignal herausragen, kann die zyklostationäre Eigenschaft-Detektion angewendet werden. Hinsichtlich der mathematischen Grundlagen der zyklostationären Eigenschaft-Detektion sei auf die Gleichungen (1) bis (9) in der US 2010/0054352 A1 verwiesen.

Der zusätzlich oder alternativ bei nicht signifikant über den Rauschteppich und den unkorrelierten Spektralanteilen des Sprachsignals hinausragenden ersten Spektrallinien anwendbare Jarque-Bera-Test berechnet aus insgesamt $n$ Abtastwerten des von zweiten Spektrallinien befreiten Spektrums des nichtlinear modifizierten Empfangssignals einen Jarque-Bera-Wert $JB$ gemäß Gleichung (31), der die Schiefe $S$ gemäß Gleichung (32) und die Kurtose $K$ gemäß Gleichung (33) enthält. Der dabei auftretende Wert $\bar{x}$ stellt den Mittelwert über alle $n$ Abtastwerte dar. Der Jarque-Bera-Wert $JB$ wird mit einem dritten Schwellwert $SW_3$ verglichen. Liegt der Jarque-Bera-Wert über dem dritten Schwellwert $SW_3$, dann existiert eine erste Spektrallinie im Spektrum des modifizierten Empfangssignals. Für höhere Werte des dritten Schwellwerts $SW_3$ können mehrere erste Spektrallinien im Spektrum des modifizierten Empfangssignals identifiziert werden. Die jeweiligen Werte des dritten Schwellwerts $SW_3$ müssen simulativ ermittelt werden.

$$JB = \frac{n}{6} \cdot \left( S^2 + \frac{(K-3)^2}{4} \right) > SW_3 \qquad (31)$$

$$S = \frac{\frac{1}{n} \cdot \sum_{i=0}^{n-1} \left( x_i - \bar{x} \right)^3}{\left( \frac{1}{n} \cdot \sum_{i=0}^{n-1} \left( x_i - \bar{x} \right)^2 \right)^{\frac{3}{2}}} \qquad (32)$$

$$K = \frac{\frac{1}{n} \cdot \sum_{i=0}^{n-1} \left( x_i - \bar{x} \right)^4}{\left( \frac{1}{n} \cdot \sum_{i=0}^{n-1} \left( x_i - \bar{x} \right)^2 \right)^2} \qquad (33)$$

Im Folgenden wird das erfindungsgemäße Verfahren zur Detektion von mindestens zwei in einem Empfangssignal enthaltenen amplitudenmodulierten Übertragungssignalen mit unterschiedlicher Frequenzverschiebung anhand des Flussdiagrammes in Fig. 5 und die zugehörige erfindungsgemäße Vorrichtung zur Detektion von mindestens zwei in einem Empfangssignal enthaltenen amplitudenmodulierten Übertragungssignalen mit unterschiedlicher Frequenzverschiebung anhand des Blockdiagramms in Fig. 6 im Detail erläutert:

Im ersten Verfahrensschritt S10 wird das Empfangssignal nach seiner Mischung ins Basisband in einer nichtlinearen Signalverarbeitungseinheit 1 einer nichtlinearen Signalverarbeitungsfunktion unterworfen. Bevorzugt wird hierbei eine quadratische Signalverarbeitungsfunktion verwendet, da diese am einfachsten zu realisieren ist und ein Spektrum des durch die nichtlineare Signalverarbeitungsfunktion erzeugten modifizierten Empfangssignals generiert, das lediglich Spektrallinien zweiter Ordnung und zugehörige obere und untere Seitenbänder aufweist.

Im nächsten Verfahrensschritt S20 wird in einem Fourier-Transformator 2 das Spektrum des modifizierten Empfangssignals mittels Fourier-Transformation ermittelt. Anstelle einer Fourier-Transformation mit anschließender Detektion von Spektrallinien kann auch der so genannte Multiple-Signal-Classification-(MUSIC)-Algorithmus oder der so genannte Estimation-of-Signal-Parameters-via-Rotational-Invariance-Techniques-(ESPRIT)-Algorithmus verwendet werden, die beide auf der Eigenwertzerlegung von Kovarianzmatrizen beruhen.

Im nächsten Verfahrensschritt S30 wird das Spektrum des modifizierten Empfangssignals mittels eines Bandpassfilters 3 auf den für die weitere Analyse relevanten Frequenzbereich eingeschränkt. Diese Einschränkung des zu analysierenden Frequenzbereichs ist abhängig von der verwendeten Nichtlinearität.

Wird eine quadratische Nichtlinearität verwendet, so deckt das Bandpassfilter 3 den Frequenzbereich ab, in dem die Harmonischen und die Intermodulationsprodukte zweiter Ordnung der Trägersignale für die im modifizierten Empfangssignal enthaltenen Übertragungssignale sowie die zugehörigen oberen und unteren Seitenbänder der Sprachsignalanteile positioniert sind.

Bei Verwendung einer Betragsfunktion als Nichtlinearität deckt das Bandpassfilter 3 den Frequenzbereich ab, der symmetrisch zur Nullfrequenz ist und die Gleichsignalanteile und Intermodulationsprodukte erster Ordnung der Trägersignale für die im modifizierten Empfangssignal enthaltenen Übertragungssignale sowie die zugehörigen oberen und unteren Seitenbänder der Sprachsignalanteile enthält.

Bei Verwendung einer Nichtlinearität höherer Ordnung - beispielsweise eine kubische Signalverarbeitungsfunktion - deckt das Bandpassfilter 3 den Frequenzbereich ab, in dem die Harmonischen und die Intermodulationsprodukte der jeweils höchsten Ordnung der Trägersignalen für die im modifizierten Empfangssignal enthaltenen Übertragungssignale sowie die zugehörigen oberen und unteren Seitenränder der Sprachsignalanteile positioniert sind.

Im nächsten Verfahrensschritt S40 werden in einer Einheit zum Ausblenden von zweiten Spektrallinien 4 im bandbegrenzten Spektrum des modifizierten Empfangssignals die zu den asymmetrisch positionierten Spektrallinien der Harmonischen und der Intermodulationsprodukte der einzelnen Trägersignale symmetrisch in den zugehörigen oberen und unteren Seitenbändern angeordneten Spektrallinien der zugehörigen Sprachsignalanteile identifiziert und anschließend aus dem bandbegrenzten Spektrum des modifizierten Empfangssignals ausgeblendet.

Diese auszublendenden zweiten Spektrallinien werden identifiziert, indem die Spektrallinie mit der höchsten Amplitude als asymmetrisch positionierte erste Spektrallinie identifiziert und als solche markiert wird und zur Spektrallinie mit der nächst kleineren Amplitude eine weitere Spektrallinie gesucht wird, deren Frequenzverschiebungs-Abstände zur Frequenzverschiebung der Spektrallinie mit der höchsten Amplitude jeweils sich maximal gemäß Gleichung (29) um einen geeignet gewählten ersten Schwellwert $SW_1$ unterscheiden und somit näherungsweise identische Frequenzverschiebungs-Abstände zur Frequenzverschiebung der Spektrallinie mit der höchsten Amplitude aufweisen. Das auf diese Weise identifizierte Paar von symmetrischen zweiten Spektrallinien wird anschließend aus dem bandbegrenzten Spektrum des modifizierten Empfangssignals ausgeblendet. Anschließend werden weitere Paare von zweiten Spektrallinien gesucht, die hinsichtlich ihrer Frequenzverschiebung symmetrisch zur Frequenzverschiebung der Spektrallinien mit der höchsten Amplitude sind, indem von den verbliebenen Spektrallinien die nächst kleinere Spektrallinie ausgewählt wird und eine weitere Spektrallinie gesucht wird, für die die Identitätsbedingung in den Frequenzverschiebung-Abständen gemäß Gleichung (29) gilt.

Sobald für die Spektrallinie mit der höchsten Amplitude sämtliche Spektrallinien hinsichtlich des Vorliegens eines Paares von symmetrischen Spektrallinien untersucht sind, wird aus allen im eingeschränkten Spektrum des modifizierten Empfangssignals verbliebenen und noch nicht als erste Spektrallinien markierten Spektrallinien die Spektrallinie mit der aktuell größten Amplitude gesucht und als asymmetrisch erste Spektrallinie markiert. Für diese aktuellen asymmetrischen ersten Spektrallinien werden die verbliebenen Spektrallinien im Hinblick auf vorliegende Paare von symmetrischen zweiten Spektrallinien untersucht. Dieser Vorgang wird solange durchgeführt, bis alle im eingeschränkten Spektrum des modifizierten Empfangssignals vorliegenden Spektrallinien entweder als asymmetrische erste Spektrallinien markiert sind oder als symmetrische zweite Spektrallinien ausgeblendet sind.

Auf diese Weise sind alle verzerrten und/oder unverzerrten periodischen Sprachsignalanteile von jedem im modifizierten Empfangssignal enthaltenen Übertragungssignal aus dem eingeschränkten Spektrum des modifizierten Empfangssignals beseitigt.

Um die asymmetrischen ersten Spektrallinien von den im eingeschränkten Spektrum des modifizierten Empfangssignals noch enthaltenen unkorrelierten Sprachsignalanteile der im modifizierten Empfangssignal enthaltenen Übertragungssignale und vom überlagerten Rauschteppich zu trennen, werden in den folgenden drei Verfahrensschritten S40, S50 und S60 zusätzliche statistische Tests im eingeschränkten Spektrum des modifizierten Empfangssignals durchgeführt. Diese statistischen Tests können entweder in Summe oder nur einzelne durchgeführt werden. Im Fall eines niedrigen Signal-Rausch-Abstands, bei dem die einzelnen Spektrallinien typischerweise nicht signifikant über die Spektralanteile der unkorrelierten Sprachsignale und des Rauschteppich hinausragen, ist lediglich eine zyklostationäre Eigenschaft-Detektion in Verfahrensschritt S50 und/oder ein Jarque-Bera-Test in Verfahrensschritt S60 durchzuführen.

Bei einem höheren Signal-Rausch-Abstand kann zusätzlich oder alternativ auch ein Signifikanz-Test in Verfahrensschritt S40 durchgeführt werden.

Beim Signifikanz-Test in Verfahrensschritt S40 werden in einem Signifikanz-Tester 5 die im eingeschränkten Spektrum des modifizierten Empfangssignals markierten asymmetrischen ersten Spektrallinien einzeln mit einem über dem Mittelwert $E\{.\}$ der verbleibenden Abtastwerte des eingeschränkten Spektrums liegenden Signifikanzniveau $SW_2$

gemäß Gleichung (30) verglichen. Dieser zweite Schwellenwert $SW_2$ des Signifikanzniveaus ist ein frei wählbarer Wert, der beispielsweise simulativ ermittelbar ist. Liegt die jeweilige asymmetrische erste Spektrallinie mit der Amplitude über dem Signifikanzniveau oberhalb des Mittelwerts $E\{.\}$ der verbleibenden Abtastwerte des eingeschränkten Spektrums, so ist eine zu einem Trägersignal eines im modifizierten Empfangssignal enthaltenen Übertragungssignals gehörige erste Spektrallinie signifikant detektiert. Die detektierte, zu einem Trägersignal gehörige erste Spektrallinie ist je nach verwendeter Nichtlinearität bei der Nullfrequenz, bei einer Vielfachen der Trägerfrequenz und/oder bei einer der Intermodulationsfrequenzen positioniert.

Bei der zyklostationären Eigenschaft-Detektion in Verfahrensschritt S50 werden in einem zyklostationären Eigenschafts-Detektor 6 die periodischen Signalanteile des modifizierten Empfangssignals von allen nicht-periodischen Signalanteilen des modifizierten Empfangssignals getrennt. Auf diese Weise werden alle im modifizierten Empfangssignal enthaltenen ersten Spektrallinien zuzüglich ihre jeweiligen Frequenzen ermittelt. Alternativ kann die zyklostationäre Eigenschaft-Detektion auch schon vor der Ermittlung der im Spektrum des modifizierten Empfangssignals enthaltenen zweiten Spektrallinien in Verfahrensschritt S30 durchgeführt werden, was von der Erfindung auch mit abgedeckt ist. In diesem Fall werden durch die zyklostationäre Eigenschafts-Detektion sowohl erste Spektrallinien als auch zweite Spektrallinien zuzüglich ihrer zugehörigen Frequenzen detektiert.

Beim Jarque-Bera-Test in Verfahrensschritt S60 werden in einem Jarque-Bera-Tester 7 für das modifizierte und von zweiten Spektrallinien befreite Empfangssignal der Jarque-Bera-Wert $JB$ gemäß Gleichungen (31) bis (33) ermittelt, der das Ausmaß des Gauss-Anteils im zu untersuchenden Signal bestimmt. Auf diese Weise lässt sich der Anteil von Spektrallinien, die keine Gauss-Charakteristik aufweisen, und der Anteil von rauschbedingten Spektralanteilen, die typischerweise einer Gauss-Verteilung genügen, im zu untersuchenden Signal ermitteln. Durch Vergleich des ermittelten Jarque-Bera-Wertes $JB$ mit einem dritten Schwellwert $SW_3$ lässt sich ermitteln, ob im zu untersuchenden Signal ein bestimmter Anteil von Spektrallinien vorliegt. Durch Wahl des dritten Schwellwerts $SW_3$ kann somit bestimmt werden, ob im zu untersuchenden modifizierten und von zweiten Spektrallinien befreiten Empfangssignal eine erste Spektrallinien oder zwei bzw. mehrere erste Spektrallinien vorhanden sind. Auch der Jarque-Bera-Test kann schon vor der Ermittlungen der im Spektrum des modifizierten Empfangssignals enthaltenen zweiten Spektrallinien in Verfahrensschritt S30 durchgeführt werden, was von der Erfindung auch mit abgedeckt ist. In diesem Fall können durch den Jarque-Bera-Test sowohl erste Spektrallinien als auch zweite Spektrallinien im modifizierten Empfangssignal detektiert werden.

In einem Detektor von mehreren ersten Spektrallinien 8 werden im nächsten Verfahrensschritt S70 sämtliche durch die vorherigen statistischen Tests detektierten ersten Spektrallinien zuzüglich ihrer Amplituden, Frequenzen und Phasen zusammengefasst. Im selben Detektor von mehreren ersten Spektrallinien 8 wird im nächsten Verfahrensschritt S80 ermittelt, ob im Spektrum des von zweiten Spektrallinien befreiten modifizierten Empfangssignals überhaupt keine ersten Spektrallinien vorliegen und somit nur ein Empfangssignal mit einem Rauschteppich vorliegt. Ist dies nicht der Fall, so wird im selben Detektor von mehreren ersten Spektrallinien 8 im darauf folgenden Verfahrensschritt S90 ermittelt, ob im Spektrum des von zweiten Spektrallinien befreiten modifizierten Empfangssignals eine einzige erste Spektrallinie vorliegt und somit im Empfangssignal nur ein einziges von einem einzigen Sender gesendetes Übertragungssignal oder ob im Spektrum des von zweiten Spektrallinien befreiten modifizierten Empfangssignals mehrere erste Spektrallinien - typischerweise drei Spektrallinien pro Übertragungssignal - vorliegen und somit im Empfangssignal im selben Empfangskanal gleichzeitig mehrere von jeweils einem Sender gesendete Übertragungssignale vorliegen.

Im Fall, dass mehrere erste Spektrallinien im modifizierten Empfangssignal identifiziert wurden und somit im Empfangssignal mehrere von jeweils einem Sender gesendete Übertragungssignale vorliegen, wird im abschließenden Verfahrensschritt S100 den Piloten in den einzelnen Flugzeugen und dem Personal in der Bodenstation das gleichzeitige Übertragen von mehreren Übertragungssignal im selben Frequenzkanal signalisiert.

Um einen Fehlalarm bei der Signalisierung von mehreren in einem Empfangssignal enthaltenen Übertragungssignalen zu verhindern, ist in der einfachsten Variante die Anzahl von Abtastwerten des Empfangssignals zu erhöhen. Die Eingangsblöcke von Abtastwerten des nichtlinear modifizierten Empfangssignals für die Durchführung der Fourier-Transformation können dabei überlappend oder nicht-überlappend sein.

Eine weitere Option zur Verhinderung von Fehlalarmen besteht darin, die Ergebnisse der einzelnen statistischen Tests über eine Entscheidungsregel zu kombinieren. Eine Entscheidungsregel könnte beispielsweise lauten, dass im modifizierten Empfangssignal mehrere Übertragungssignale enthalten sind, wenn dies gleichzeitig von mindestens zwei statistischen Test - dem Signifikanz-Test, der zyklostationären Eigenschaft-Detektion und dem Jarque-Bera-Test - ermittelt wurde. Eine weitere beispielhafte Entscheidungsregel für das Vorliegen von mehreren Übertragungssignalen im modifizierten Empfangssignal läge vor, wenn die zyklostationäre Eigenschaft-Direktion und der Jarque-Bera-Test mehrere Male hintereinander dies detektieren würde.

Eine dritte Variante zur Verhinderung von Fehlalarmen besteht darin, den Mittelwert der in mehreren Zyklen jeweils detektierten ersten Spektrallinien zu bestimmen und die gemittelten ersten Spektrallinien mit dem gemittelten Rauschteppich und/oder dem gemittelten übrigen Spektrallinien, d.h. den gemittelten zweiten Spektrallinien, zu vergleichen. Vorteil dieser Variante ist eine Reduzierung der Wahrscheinlichkeit für Fehlalarme bei gleichzeitiger Erhöhung der Detektionswahrscheinlichkeit.

**Patentansprüche**

1. Verfahren zur Detektion von mindestens zwei in einem Empfangssignal enthaltenen amplitudenmodulierten Übertragungssignalen im selben Frequenzkanal mit jeweils unterschiedlicher Frequenzverschiebung mit folgenden Verfahrensschritten:

   - Ermitteln (S10) eines modifizierten Empfangssignals mittels nicht-linearer Signalverarbeitung des Empfangssignals,
   - Ermitteln (S20) eines Spektrums des modifizierten Empfangssignals mittels Fourier-Transformation und
   - Detektion (S30-S100) von mindestens zwei im Empfangssignal enthaltenen amplitudenmodulierten Übertragungssignalen, falls im ermittelten Spektrum mindestens zwei erste Spektrallinien von im modifizierten Empfangssignal enthaltenen Trägersignalen identifiziert werden, deren Amplituden jeweils ein Vielfaches des Mittelwerts der Amplitude der Spektralanteile der im modifizierten Empfangssignal enthaltenen Rausch- und Nutzsignale sind,

   wobei symmetrisch zu den ersten Spektrallinien positionierte, zweite Spektrallinien der im modifizierten Empfangssignal enthaltenen periodischen Signalanteile des Nutzsignals identifiziert und aus dem ermittelten Spektrum des modifizierten Empfangssignals ausgeblendet werden..

2. Verfahren zur Detektion nach Anspruch 1,
   **dadurch gekennzeichnet,**
   **dass** die identifizierten ersten Spektrallinien der Trägersignale Gleichsignalanteile, Harmonische und/oder Intermodulationsprodukte sind.

3. Verfahren zur Detektion nach Anspruch 2,
   **dadurch gekennzeichnet,**
   **dass** zwei symmetrisch zu einer ersten Spektrallinie positionierte zweite Spektrallinien identifiziert werden, falls für jeweils eine identifizierte erste Spektrallinie jeweils zwei Spektrallinien existieren, deren Abstände in den Frequenzverschiebungen zur jeweiligen ersten Spektrallinie sich maximal um einen ersten Schwellwert ($SW_1$) unterscheiden.

4. Verfahren zur Detektion nach einem der Ansprüche 1 bis 3,
   **dadurch gekennzeichnet,**
   **dass** zur Identifizierung von zweiten Spektrallinien als erste Spektrallinien jeweils die Spektrallinien mit den größten Amplituden im Spektrum des modifizierten Empfangssignals verwendet werden.

5. Verfahren zur Detektion nach Anspruch 3 ,
   **dadurch gekennzeichnet,**
   **dass** zur Erhöhung der Frequenzauflösung bei der Ermittlung der Abstände in den Frequenzverschiebungen die FFT-Länge der Fourier-Transformation erhöht wird.

6. Verfahren zur Detektion nach einem der Ansprüche 1 bis 5,
   **dadurch gekennzeichnet,**
   **dass** mindestens zwei im Empfangssignal enthaltene amplitudenmodulierte Übertragungssignale detektiert werden, wenn nach Ausblendung der zweiten Spektrallinien mindestens drei erste Spektrallinien im Spektrum des modifizierten Empfangssignals identifiziert werden, deren Amplituden jeweils ein Vielfaches des Mittelwerts der Amplitude der Spektralanteile von im modifizierten Empfangssignal enthaltenen nicht-periodischen Signalanteilen sind.

7. Verfahren zur Detektion nach Anspruch 6,
   **dadurch gekennzeichnet,**
   **dass** im modifizierten Empfangssignal mindestens zwei amplitudenmodulierte Übertragungssignale detektiert (S40) werden, falls nach Ausblendung von zweiten Spektrallinien mindestens drei Spektrallinien im Spektrum des modifizierten Empfangssignals befindet, deren Amplituden höher als ein durch einen zweiten Schwellwert ($SW_2$) charakterisiertes Signifikanzniveau oberhalb des Mittelwerts der Amplituden der Spektralanteile des im modifizierten Empfangssignal enthaltenen nicht-periodischen Signalanteilen sind.

8. Verfahren zur Detektion nach Anspruch 6 oder 7, **dadurch gekennzeichnet,**
   **dass** im modifizierten Empfangssignal mindestens zwei amplitudenmodulierte Übertragungssignale detektiert (S50) werden, falls nach Ausblendung von zweiten Spektrallinien sich mindestens drei Spektrallinien im Spektrum des modifizierten Empfangssignals befinden, die mittels zyklostationärer Eigenschafts-Detektion von den nichtperiodischen Signalanteilen im modifizierten Empfangssignal selektiert werden.

9. Verfahren zur Detektion nach einem der Ansprüche 6 bis 8,
**dadurch gekennzeichnet,**
**dass** im modifizierten Empfangssignal mindestens zwei weitere amplitudenmodulierte Übertragungssignale detektiert (S60) werden, falls nach Ausblendung von zweiten Spektrallinien sich mindestens drei Spektrallinien im Spektrum des modifizierten Empfangssignals befinden, die mittels Jarque-Bera-Test von den nichtperiodischen Signalanteilen im modifizierten Empfangssignal selektiert werden.

10. Verfahren zur Detektion nach einem der Ansprüche 1 bis 9,
**dadurch gekennzeichnet,**
**dass** die nicht-lineare Signalverarbeitung eine quadratische Signalverarbeitung ist.

11. Verfahren zur Detektion nach Anspruch 10,
**dadurch gekennzeichnet,**
**dass** für die Identifikation von ersten und zweiten Spektrallinien das Spektrum des modifizierten Empfangssignals im Frequenzbereich der zweiten Harmonischen der im modifizierten Empfangssignal enthaltenen amplitudenmodulierten Übertragungssignale analysiert wird.

12. Verfahren zur Detektion nach einem der Ansprüche 1 bis 9,
**dadurch gekennzeichnet,**
**dass** die nicht-lineare Signalverarbeitung eine Betragsfunktion ist.

13. Verfahren zur Detektion nach Anspruch 12,
**dadurch gekennzeichnet,**
**dass** für die Identifikation von ersten und zweiten Spektrallinien das Spektrum des modifizierten Empfangssignals im Frequenzbereich in der Umgebung des Gleichsignalanteils des modifizierten Empfangssignals analysiert wird.

14. Vorrichtung zur Detektion von mindestens zwei in einem Empfangssignal enthaltenen amplitudenmodulierten Übertragungssignalen mit unterschiedlicher Frequenzverschiebung mit
einer nicht-linearen Signalverarbeitungs-Einheit (1) zur Ermittlung eines modifizierten Empfangssignals durch nichtlineare Signalverarbeitung des Empfangssignals,
einem Fourier-Transformator (2) zur Ermittlung eines Spektrums des modifizierten Empfangssignals,
einer Einheit (4) zum Ausblenden von zweiten Spektrallinien aus dem Spektrum des modifizierten Empfangssignals, die symmetrisch zu den ersten Spektrallinien positioniert sind, und
einem Detektor (8) zur Identifikation von mehreren zu Trägersignalen jeweils gehörigen ersten Spektrallinien, deren Amplituden jeweils ein Vielfaches des Mittelwerts der Amplitude von Spektralanteilen von im modifizierten Empfangssignal enthaltenen Rausch- und Nutzsignalen sind.

15. Vorrichtung zur Detektion nach Anspruch 14,
**dadurch gekennzeichnet,**
**dass** zusätzlich eine Einheit (5) zur Durchführung eines Signifikanz-Tests vorgesehen ist.

16. Vorrichtung zur Detektion nach Anspruch 14 oder 15, **dadurch gekennzeichnet,**
**dass** zusätzlich eine Einheit (6) zur Durchführung einer zyklostationären Eigenschaft-Detektion vorgesehen ist.

17. Vorrichtung zur Detektion nach einem der Ansprüche 14 bis 16,
**dadurch gekennzeichnet,**
**dass** zusätzlich eine Einheit (7) zur Durchführung eines Jarque-Bera-Tests vorgesehen ist.

**Claims**

1. Method for detection of at least two amplitude-modulated transmitted signals which are contained in a received signal in the same frequency channel with in each case a different frequency shift with the following method steps:

- determination (S10) of a modified received signal by means of non-linear signal processing of the received signal,
- determination (S20) of a spectrum of the modified received signal by means of fast Fourier transformation and
- detection (830-8100) of at least two amplitude-modulated transmitted signals contained in the received signal if at least two first spectral lines of carrier signals contained in the modified received signal with amplitudes which are in each case a multiple of the mean value of the amplitude of the spectral components of the noise and useful signals contained in the modified received signal, are identified in the determined spectrum,

wherein second spectral lines of the periodic signal components of the useful signal contained in the modified received signal positioned symmetrically to the first spectral lines are identified and blanked out of the determined spectrum of the modified received signal.

2. Method for detection according to claim 1, **characterised in that**
the identified first spectral lines of the carrier signals are direct signal components, harmonics and/or intermodulation products.

3. Method for detection according to claim 2, **characterised in that**
two second spectral lines positioned symmetrically to a first spectral line are identified if in each case two spectral lines exist for each identified first spectral line having intervals in the frequency shifts with respect to the respective first spectral line which differ by a maximum of a first threshold value ($SW_i$).

4. Method for detection according to one of claims 1 to 3,
**characterised in that**
the spectral lines with the greatest amplitudes in the spectrum of the modified received signal are used as the first spectral lines for identification of second spectral lines.

5. Method for detection according to claim 3, **characterised in that**
the FFT length of the Fourier transformation is increased to increase the frequency resolution for determination of the intervals in the frequency shifts.

6. Method for detection according to one of claims 1 to 5,
**characterised in that**
at least two amplitude-modulated transmitted signals contained in the received signal are detected if after the second spectral lines are blanked out, at least three first spectral lines are identified in the spectrum of the modified received signal with amplitudes which are in each case a multiple of the mean value of the amplitude of the spectral components of non-periodic signal components contained in the modified received signal.

7. Method for detection according to claim 6, **characterised in that**
at least two amplitude-modulated transmitted signals are detected in the modified received signal (S40) if after the second spectral lines are blanked out, there are at least three spectral lines in the spectrum of the modified received signal with amplitudes which are higher than a significance level **characterised by** a second threshold value ($SW_2$) above the mean value of the amplitudes of the spectral components of the non-periodic signal components contained in the modified received signal.

8. Method for detection according to claim 6 or 7, **characterised in that**
at least two amplitude-modulated transmitted signals are detected in the modified received signal (S50) if after the second spectral lines are blanked out, there are at least three spectral lines in the spectrum of the modified received signal which are selected from the non-periodic signal components in the modified received signal by means of cyclostationary property detection.

9. Method for detection according to one of claims 6 to 8,
**characterised in that**
at least two further amplitude-modulated transmitted signals are detected in the modified received signal (S60) if after the second spectral lines are blanked out, there are at least three spectral lines in the spectrum of the modified received signal which are selected from the non-periodic signal components in the modified received signal by means of a Jarque-Bera-Test.

10. Method for detection according to one of claims 1 to 9,
**characterised in that**

the non-linear signal processing is quadratic signal processing.

11. Method for detection according to claim 10, **characterised in that**
the spectrum of the modified received signal in the frequency range of the second harmonic of the amplitude-modulated transmitted signals contained in the modified received signal is analysed for identification of first and second spectral lines.

12. Method for detection according to one of claims 1 to 9,
**characterised in that**
the non-linear signal processing is an absolute value function.

13. Method for detection according to claim 12, **characterised in that**
the spectrum of the modified received signal in the frequency range in the vicinity of the direct signal component of the modified received signal is analysed for identification of first and second spectral lines.

14. Device for detection of at least two amplitude-modulated transmitted signals which are contained in a received signal with a different frequency shift with:

   - a non-linear signal processing unit (1) for determination of a modified received signal by non-linear processing of the received signal,
   - a Fourier transformer (2) for determination of a spectrum of the modified received signal,
   - a unit (4) for blanking out second spectral lines from the spectrum of the modified received signal which are positioned symmetrically to the first spectral lines, and
   - a detector (8) for identification of a plurality of first spectral lines in each case belonging to carrier signals with amplitudes which are in each case a multiple of the mean value of the amplitude of spectral lines of noise and useful signals contained in the modified received signal.

15. Device for detection according to claim 14, **characterised in that**
in addition a unit (5) for carrying out a significance test is provided.

16. Device for detection according to claim 14 or 15, **characterised in that**
in addition a unit (6) for carrying out cyclostationary property detection is provided.

17. Device for detection according to one of claims 14 to 16,
**characterised in that**
in addition a unit (7) for carrying out a Jarque-Bera-Test is provided.


**Revendications**

1. Procédé de détection d'au moins deux signaux de transmission modulés en amplitude contenus dans un signal de réception dans le même canal de fréquence et présentant un décalage de fréquence respectivement différent, comprenant les étapes suivantes :

   • déterminer (S10) un signal de réception modifié au moyen d'un traitement non linéaire de signal du signal de réception,
   • déterminer (S20) un spectre du signal de réception modifié au moyen d'une transformée de Fourier et
   • détecter (S30-S100) au moins deux signaux de transmission modulés en amplitude et contenus dans le signal de réception, au cas où, dans le spectre déterminé, au moins deux premières lignes spectrales de signaux porteurs contenus dans le signal de réception modifié seraient identifiées, lignes dont les amplitudes sont respectivement un multiple de la valeur moyenne de l'amplitude des composants spectrales des signaux de bruit et utiles contenus dans le signal de réception modifié,

   dans lequel des deuxièmes lignes spectrales, positionnées de manière symétrique par rapport aux premières lignes spectrales, des composantes périodiques de signal du signal utile contenues dans le signal de réception modifié sont identifiées et supprimées du spectre déterminé du signal de réception modifié.

2. Procédé de détection selon la revendication 1,

**caractérisé**

**en ce que** les premières lignes spectrales identifiées des signaux porteurs sont des composantes de signal continu, des harmoniques et/ou des produits d'intermodulation.

3. Procédé de détection selon la revendication 2,
   **caractérisé**
   **en ce que** deux deuxièmes lignes spectrales positionnées de manière symétrique par rapport à une première ligne spectrale sont identifiées, au cas où, pour respectivement une première ligne spectrale identifiée, il existerait respectivement deux lignes spectrales dont les écarts dans les décalages de fréquence par rapport à la première ligne spectrale respective se distinguent aux maximum d'une première valeur seuil ($SW_1$).

4. Procédé de détection selon l'une quelconque des revendications 1 à 3,
   **caractérisé**
   **en ce que**, pour l'identification des deuxièmes lignes spectrales comme des premières lignes spectrales, respectivement les lignes spectrales présentant les plus grandes amplitudes dans le spectre du signal de réception modifié sont utilisées.

5. Procédé de détection selon la revendication 3,
   **caractérisé**
   **en ce que**, pour l'augmentation de la résolution de fréquence lors de la détermination des écarts dans les décalages de fréquence, la longueur FFT de la transformée de Fourier est augmentée.

6. Procédé de détection selon l'une quelconque des revendications 1 à 5,
   **caractérisé**
   **en ce qu'**au moins deux signaux de transmission modulés en amplitude contenus dans le signal de réception sont détectés lorsque, après la suppression des deuxièmes lignes spectrales, au moins trois premières lignes spectrales sont identifiées dans le spectre du signal de réception modifié, lignes dont les amplitudes sont respectivement un multiple de la valeur moyenne de l'amplitude des composantes spectrales de composantes de signal non périodique contenues dans le signal de réception modifié.

7. Procédé de détection selon la revendication 6,
   **caractérisé**
   **en ce que**, dans le signal de réception modifié, au moins deux signaux de transmission modulés en amplitude sont détectés (S40), au cas où, après la suppression des deuxièmes lignes spectrales, au moins trois lignes spectrales se situeraient dans le spectre du signal de réception modifié, lignes dont les amplitudes sont supérieures à un niveau de signification **caractérisé par** une deuxième valeur seuil ($SW_2$) située au-dessus de la valeur moyenne des amplitudes des composantes spectrales des composantes de signal non périodique contenues dans le signal de réception modifié.

8. Procédé de détection selon la revendication 6 ou 7,
   **caractérisé**
   **en ce que**, dans le signal de réception modifié, au moins deux signaux de transmission modulés en amplitude sont détectés (S50), au cas où, après la suppression des deuxièmes lignes spectrales, au moins trois lignes spectrales se situeraient dans le spectre du signal de réception modifié, qui sont sélectionnées dans le signal de réception modifié parmi les composantes de signal non périodique au moyen d'une détection de propriété cyclostationnaire.

9. Procédé de détection selon l'une quelconque des revendications 6 à 8,
   **caractérisé**
   **en ce que**, dans le signal de réception modifié, au moins deux autres signaux de transmission modulés en amplitude sont détectés (S60), au cas où, après la suppression des deuxièmes lignes spectrales, au moins trois lignes spectrales se situeraient dans le spectre du signal de réception modifié, qui sont sélectionnées dans le signal de réception modifié parmi les composantes de signal non périodique au moyen du test de Jarque-Bera.

10. Procédé de détection selon l'une quelconque des revendications 1 à 9,
    **caractérisé en ce que**
    le traitement non linéaire de signal est un traitement de signal quadratique.

11. Procédé de détection selon la revendication 10,

**caractérisé**

**en ce que**, pour l'identification de premières et deuxièmes lignes spectrales, le spectre du signal de réception modifié est analysé dans la plage de fréquence des deuxièmes harmoniques des signaux de transmission modulés en amplitude contenus dans le signal de réception modifié.

12. Procédé de détection selon l'une quelconque des revendications 1 à 9,
**caractérisé**
**en ce que** le traitement non linéaire de signal est une fonction valeur absolue.

13. Procédé de détection selon la revendication 12,
**caractérisé**
**en ce que**, pour l'identification des premières et deuxièmes lignes spectrales, le spectre du signal de réception modifié est analysé dans la plage de fréquences dans l'environnement de la composante de signal continu du signal de réception modifié.

14. Dispositif de détection d'au moins deux signaux de transmission modulés en amplitude contenus dans un signal de réception et présentant un décalage de fréquence différent, comprenant
une unité de traitement non linéaire de signal (1) destinée à déterminer un signal de réception modifié par traitement non linéaire de signal du signal de réception,
un transformateur de Fourier (2) destiné à déterminer un spectre du signal de réception modifié,
une unité (4) destinée à supprimer des deuxièmes lignes spectrales du spectre du signal de réception modifié, lesquelles sont positionnées de manière symétrique par rapport aux premières lignes spectrales, et
un détecteur (8) destiné à identifier plusieurs premières lignes spectrales respectivement associées aux signaux porteurs, lignes dont les amplitudes sont respectivement un multiple de la valeur moyenne de l'amplitude de composantes spectrales de signaux de bruit et utiles contenus dans le signal de réception modifié.

15. Dispositif de détection selon la revendication 14,
**caractérisé**
**en ce qu'**une unité (5) destinée à réaliser un test de signification est prévu en plus.

16. Dispositif de détection selon la revendication 14 ou 15,
**caractérisé**
**en ce qu'**une unité (6) destinée à réaliser une détection de propriété cyclostationnaire est prévue en plus.

17. Dispositif de détection selon l'une quelconque des revendications 14 à 16,
**caractérisé**
**en ce qu'**une unité (7) destinée à réaliser un test de Jarque-Bera est prévue en plus.

Fig. 1A

Fig. 1B

Fig. 2A

Fig. 2B

$|F(r(k))|$

4000
3500
3000
2500
2000
1500
1000
500

0    500   1000  1500  2000  2500  3000  3500  4000  4500

$f_1$    $f_2$

Frequenzverschiebung f

## Fig. 3A

$|F(r(k)^2)|$

3500
3000
2500
2000
1500
1000
500

0    500   1000  1500  2000  2500  3000  3500  4000  4500

$f_1$    $f_2$

Frequenzverschiebung f

## Fig. 3B

$|F(|r(k)|^2)|$

A'

C'

$a_2{}^2$

$a_1{}^2$

B'

D'    D'    G'

Frequenzverschiebung f

## Fig. 4

Fig. 5

Fig. 6

EP 2 745 396 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20100067570 A1
- DE 102007037105 A1

- US 20100054352 A1